Europäisches Patentamt

European Patent Office

Office européen des brevets

(11) Publication number: 0 353 878
A1

# EUROPEAN PATENT APPLICATION

(21) Application number: 89306971.6

(22) Date of filing: 10.07.89

(51) Int. Cl.⁴: G03F 7/32

(30) Priority: 28.07.88 US 225449

(43) Date of publication of application:
07.02.90 Bulletin 90/06

(84) Designated Contracting States:
AT BE CH DE FR GB IT LI LU NL SE

(71) Applicant: M & T CHEMICALS, INC.
One Woodbridge Center
Woodbridge, New Jersey 07095(US)

(72) Inventor: Hung, Paul L. K.
428 Durham Avenue
Edison, N.J. 08872(US)
Inventor: Tseng, Kenneth K.S.
19 Traci Lane
Edison New Jersey 08817(US)

(74) Representative: Paget, Hugh Charles Edward
et al
MEWBURN ELLIS 2 Cursitor Street
London EC4A 1BQ(GB)

(54) Developer composition for solvent-developable photoresist coatings.

(57) The present specification describes an aqueous developer composition which can develop solvent developable photosensitive materials and comprises a surfactant, a terpene and water, in defined proportions. In a preferred form, the composition includes about 0.5-10% by wt. of a surfactant, and about 0.2-10% by wt. of a terpene, the rest being water. Most preferably, the composition comprises about 3-6% by wt. of a surfactant, and about 4-8% by wt. of a terpene, the rest being water. The surfactant is preferably a non-ionic surfactant or mixture thereof, and the terpene is d-limonene.

A concentrate formulation also is provided herein from which the aqueous developer composition may be made by dilution with water, usually in an amount of about five to ten times of the concentrate.

EP 0 353 878 A1

## DEVELOPER COMPOSITION FOR SOLVENT-DEVELOPABLE PHOTORESIST COATINGS

This invention relates to developer compositions for photoresist materials.

Photosensitive compositions particularly useful as photoresists in making printed circuit boards are well known in the art. Generally, these photoresists are referred to as being dry or liquid photoimageable solder masks. In operation as a photoresist layer, the solder mask is imagewise exposed to actinic radiation before or after the exposure step. The unexposed areas of the light-sensitive layer are then washed away in the development step forming a resist image of polymeric material.

We are aware of the following prior art documents relating to this field: US-A-2 760 863, US-A-3 469 982, US-A-4 716 093, and US-A-4 499 163. Other U.S. patents of background interest are 3 642 644, 4 199 482, 4 256 611, 4 336 152, 4 362 638, 4 414 128, 4 438 009 and 4 511 488.

Photoresists which are developable with an organic solvent are referred to as "solvent developable" photoresists. For these it has been necessary to use organic solvents such as 1,1,1-trichloroethylene to develop the coatings. However, such volatile solvents represent a hazard in the workplace.

The task addressed by the invention is to provide an aqueous developer composition capable of developing and/or stripping photosensitive material, which may ordinarily have been developable by organic solvents only.

The inventors have discovered that an aqueous composition capable of developing photosensitive materials can be made using a surfactant and a terpene in water. Suitably the composition comprises about 0.5-10 wt% of surfactant and about 0.2-10 wt% of terpene, substantially the rest being water. More preferred proportions are about 3-6 wt% surfactant, and 4-8 wt% terpene.

In a second aspect the invention provides a concentrate formulation from which a composition as set out above may be made by dilution with water, preferably five- to ten-fold.

In a third aspect the invention provides a method of developing a photoimaged solder mask coating using a terpene and surfactant aqueous composition as described.

Surprisingly it has been found that in this way an aqueous composition can be prepared that is effective in developing photoresist materials.

Terpene-based aqueous cleaning or laundry prespotting compositions containing surfactants are known in the art. See, for example, US-A-4 336 152, US-A-4 362 638, US-A-4 414 128, US-A-4 438 009 and US-A-4 511 488. However, such compositions invariably include large amounts of such terpenes as d-limonene, and small amounts of water, and include hydrocarbon solvents, and/or polar organic solvents, solubilisers, coupling agents and other additives, to provide clear, stable, aqueous cleaning solutions which do not separate upon standing.

In the present invention however the developer composition is usually a milky emulsion and the concentrate a viscous clear liquid. A clear solution is not necessary and so coupling agents etc. may be left out from concentrate or diluted formulation.

The surfactant component used in the invention may be an ionic, non-ionic or amphoteric surfactant. Non-ionic surfactants or mixtures thereof are preferred. Accordingly, the invention will be described hereinafter with particular reference to the use of non-ionic surfactants.

By way of example, the following non-ionic surfactants may be used:

| Group | Non-ionic Surfactants (Trade Marks) | | Company | Chemical Name |
|---|---|---|---|---|
| (A) | Triton | DF-12 DT-16 DT-20 | (Rohm & Haas) | Modified polyethexylated straight chain alcohol |
| | Rexonic | 1012-6 | (Hart Chemical) | Ethoxylated linear alcohol |
| | Neodol | 25-7 25-9 25-12 45-13 45-7 | (Shell Chemical Co.) | Ethoxylated linear primary alcohol |
| | Plurafac | B-25 B-25-5 C-17 | (BASF) | Modified oxyethylated straight chain alcohol |
| (B) | Triton | X-100 X-102 X-114 X-101 X-111 | (Rohm & Haas) | octylphenoxy polyethoxy ethanol |
| | Igepal | CA 620 CA 630 CA 720 CO 610 CO 620 CO 660 DM 710 | (GAF) | octylphenoxypoly (ethyleneoxy) ethanol |
| | | | | dialkylphenoxypoly (ethyleneoxy) ethanol |
| | Surfonic | N-85 N-95 N-100 N-102 N-120 N-150 | (Texaco Chemical Co.) | nonylphenoxy polyethoxy ethanol |
| | Poly-Tergent | B-300 B-350 B-500 | (Olin Corp.) | nonylphenoxy polyethoxyethanol |

Suitable terpenes are one or more mono- and bicyclic monoterpenes, especially those of the hydrocarbon class, which may be terpinenes, terpinolenes, limonenes or pinenes. The preferred terpene is d-limonene (obtainable from PDM, Inc.). Others which are suitable are e.g. dipentene, pinene, and α-pinene.

An optional constituent in the composition is a defoamer, such as Bubble Breaker 3056A (Witco); Lanco Vp 330 (G.M. Langer); Foamaster NS-1 (Henkel); or Anti-Bubble L (G.M. Langer). These names are trade marks of the companies concerned. The defoamer may be included in the applying formulation, suitably in an amount of 0.1 to 1 wt% of the aqueous composition, preferably about 0.3 to 0.5 wt%.

The concentrate formulation of the second aspect of the invention preferably comprises 35-65 parts by weight of surfactant and 40-55 parts by weight of terpene. It may be diluted five to ten times with water for application. A particularly preferred composition has 30-50 wt% of ethoxylated straight chain alcohol, 5-15 wt% of alkyl phenoxy polyethoxy ethanol, 40-55 wt% of d-limonene, and 0.3-0.5 wt% of defoamer. This may be diluted about ten times with water to provide a formulation for application.

The following are examples of concentrate formulations:

Example 1

|     |              | PBW |
| --- | ------------ | --- |
| (A) | Triton DF-16 | 45  |
| (B) | Igepal CA630 | 8   |
| (C) | d-Limonene   | 42  |
| (D) | Lanco VP330  | 5   |

Example 2

|     |             | PBW |
| --- | ----------- | --- |
| (A) | Triton DF-12 | 40 |
| (B) | Triton N-11 | 10  |
| (C) | d-Limonene  | 47  |
| (D) | Lanco VP330 | 3   |

Example 3

|     |               | PBW |
| --- | ------------- | --- |
| (A) | Triton DF-16  | 42  |
| (B) | Surfonic N-120 | 8  |
| (C) | d-Limonene    | 45  |
| (D) | Foamaster NS-1 | 5  |

Example 4

|     |              | PBW |
| --- | ------------ | --- |
| (A) | Triton DF-16 | 40  |
| (B) | Igepal CA720 | 15  |
| (C) | d-Limonene   | 40  |
| (D) | Antibubble L | 5   |

Example 5

|     |              | PBW |
| --- | ------------ | --- |
| (A) | Triton DF-12 | 40  |
| (B) | Triton X-100 | 7   |
| (C) | d-Limonene   | 50  |
| (D) | Bubble Breaker | 3 |

Example 6

|     |                   | PBW |
| --- | ----------------- | --- |
| (A) | Triton X-102      | 10  |
| (B) | DT-16             | 40  |
| (C) | d-limonene        | 45  |
| (D) | Bubble Breaker 3056A | 5 |

Example 7

|     |              | PBW |
| --- | ------------ | --- |
| (A) | Triton DF-20 | 45  |
| (B) | Triton N-101 | 10  |
| (C) | d-Limonene   | 40  |
| (D) | Lanco VP330  | 5   |

Example 8

|     |               | PBW |
| --- | ------------- | --- |
| (A) | Rexonic 1012-6 | 50 |
| (B) | Triton X-114  | 5   |
| (C) | d-Limonene    | 40  |
| (D) | Antibubble L  | 5   |

Example 9

|     |               | PBW |
| --- | ------------- | --- |
| (A) | Neodol 27-7   | 50  |
| (B) | Triton X-102  | 5   |
| (C) | d-Limonene    | 40  |
| (D) | Foamaster NS-1 | 5  |

Example 10

|     |              | PBW |
| --- | ------------ | --- |
| (A) | Neodol 27-9  | 30  |
| (B) | Igepal CA-620 | 10 |
| (C) | d-Limonene   | 55  |
| (D) | Lanco VP330  | 5   |

Example 11

|     |              | PBW |
| --- | ------------ | --- |
| (A) | Neodol 45-13 | 45  |
| (B) | Triton N-111 | 10  |
| (C) | d-Limonene   | 40  |
| (D) | Antibubble L | 5   |

Example 12

|     |               | PBW |
| --- | ------------- | --- |
| (A) | Plurofac B-25 | 40  |
| (B) | Igepal CO 610 | 7   |
| (C) | d-Limonene    | 50  |
| (D) | Foamaster NS-1 | 3  |

Example 13

|     |                | PBW |
| --- | -------------- | --- |
| (A) | Plurafac B-25-5 | 45 |
| (B) | Igepal DM710   | 8   |
| (C) | d-Limonene     | 42  |
| (D) | Lanco VP-330   | 5   |

Example 14

|     |              | PBW |
| --- | ------------ | --- |
| (A) | Neodol 45-7  | 40  |
| (B) | Triton N-111 | 15  |
| (C) | d-Limonene   | 40  |
| (D) | Antibubble L | 5   |

Example 15

|     |                | PBW |
| --- | -------------- | --- |
| (A) | Plurafac C-17  | 40  |
| (B) | Surfonic N-95  | 10  |
| (C) | d-Limonene     | 7   |
| (D) | Bubble Breaker 3056A | 3 |

Example 16

|     |                | PBW |
| --- | -------------- | --- |
| (A) | Triton DF-12   | 32  |
| (B) | Surfonic N-102 | 8   |
| (C) | d-Limonene     | 55  |
| (D) | Antibubble L   | 5   |

Example 17

|     |                  | PBW |
| --- | ---------------- | --- |
| (A) | Triton DF-16     | 40  |
| (B) | Poly-Tergent B-300 | 10 |
| (C) | d-Limonene       | 45  |
| (D) | Foamaster NS-1   | 5   |

Example 18

|     |                | PBW |
| --- | -------------- | --- |
| (A) | Neodol 25-12   | 42  |
| (B) | Surfonic N-100 | 8   |
| (C) | d-Limonene     | 45  |
| (D) | Lanco VP-330   | 5   |

Example 19

|     |                | PBW |
| --- | -------------- | --- |
| (A) | Neodol 45-7    | 45  |
| (B) | Igepal CO-620  | 10  |
| (C) | d-Limonene     | 40  |
| (D) | Foamaster NS-1 | 5   |

Example 20

|     |                | PBW |
| --- | -------------- | --- |
| (A) | Triton DF-20   | 40  |
| (B) | Triton X-114   | 10  |
| (C) | d-Limonene     | 45  |
| (D) | Bubble Breaker 3056A | 5 |

4

Specific embodiments of the composition were used in the following examples of solder mask coating development.

A typical urethane acrylate solder mask which is ordinarily developable with organic solvents only has the following composition.

| Components | Parts by Weight |
|---|---|
| RCP-785 (Diamond Shamrock) | 50.0 |
| Photomer 4028 (ibid) | 8.0 |
| Photomer 4149 (ibid) | 10.0 |
| Photomer 4061 (ibid) | 16.0 |
| Pentaerythritol Triacrylate (Sartomer) | |
| Pentaerythritol 3-(Mercaptopropionate) (Evans) | 5.0 |

| Components | Parts by Weight |
|---|---|
| Irgacure 651 | 5.0 |
| CNF-852 (20% green Pigment dispersion in Hexanediol Diacrylate) | 0.75 |
| Modaflow (Monsanto) | 0.94 |
| Cab-O-Sil (Cabot) | 3.98 |
| Hydroquinone | 0.08 |

A copper-clad epoxy fibreglass printed circuit board was cleaned by scrubbing to remove corrosion and foreign material and coated by screen printing with a photo-imageable solder mask having the composition given above to a thickness of about 0.076mm (3 mils). Thereafter another 0.076mm (3 mils) thick coating was applied onto a phototool in accordance with the method given in US-A-4 506 004, Example 2. The two coatings were then mated to form a composite coating of 0.15mm (6 mils) thickness, turned over, and given a main exposure with 0.5 joules per cm$^2$ for 30 seconds. The unexposed areas on the board were then subjected to aqueous development on a conveyored unit using a composition prepared by ten fold water dilution of developer concentrates of Examples 1-20. The developer temperature was 32-38° C (90-100° F) and the spray pressure was 1050g/cm$^2$ (15 psi). The conveyor speed was set to a developing rate of one thousandth of an inch (0.0254mm) per minute.

Upon completion of aqueous development, there was no residue on the laminate, the solder mask surface, the metal pad or the plated-through holes as observed under microscopic examination. There was also no developer attack on the coating. Cleanliness of the metal surface was determined by an immersion tin test All the pads had deposited tin in under 30 seconds in the immersion test.

**Claims**

1. a developer composition for developing solder mask coatings, characterised in that it comprises:
   (a) about 0.5-10% by weight of surfactant; and
   (b) about 0.2-10% by weight of terpene; in water.

2. A developer composition according to claim 1 comprising:
   (a) about 3-6% by weight of surfactant;
   (b) about 4-8% by weight of terpene.

3. A developer composition according to claim 1 or claim 2, in the form of an emulsion.

4. A developer composition according to any one of the preceding claims wherein the terpene is d-limonene.

5. A developer composition according to any one of the preceding claims, further including a defoaming agent.

6. A developer composition according to any one of the preceding claims wherein said surfactant is a non-ionic surfactant, or a mixture of non-ionic surfactants.

7. a developer composition concentrate for solder masks comprising:

(a) about 35-65 parts by weight of surfactant, and

(b) about 40-55 parts by weight of terpene.

8. A concentrate according to claim 7 which upon five to ten-fold dilution with water provides a composition in accordance with any one of claims 1 to 6.

9. Use of a composition or concentrate according to any one of the preceding claims as a solder mask developer.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| Y | US-A-3 019 105 (D.N. ADAMS) <br> * Column 2, line 8; claims 1-9 * | 1-9 | G 03 F 7/32 |
| Y | EP-A-0 228 676 (BASF) <br> * Whole document * | 1-9 | |

TECHNICAL FIELDS SEARCHED (Int. Cl.5)

G 03 F

The present search report has been drawn up for all claims

| Place of search | Date of completion of the search | Examiner |
|---|---|---|
| THE HAGUE | 07-11-1989 | RASSCHAERT A. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document